Europäisches Patentamt

European Patent Office

Office européen des brevets

(11) Publication number: **0 451 735 A2**

# EUROPEAN PATENT APPLICATION

(21) Application number: 91105459.1

(22) Date of filing: 06.04.91

(51) Int. Cl.⁵: **G03F 3/10, G03F 7/28**

(30) Priority: **10.04.90 US 507687**

(43) Date of publication of application:
**16.10.91 Bulletin 91/42**

(84) Designated Contracting States:
**DE FR GB IT NL**

(71) Applicant: **E.I. DU PONT DE NEMOURS AND COMPANY**
**1007 Market Street**
**Wilmington Delaware 19898(US)**

(72) Inventor: **Patricia, Jeffrey Jude**
**400 Main Street**
**Vestal, New York 13850(US)**

(74) Representative: **Werner, Hans-Karsten, Dr. et al**
**Deichmannhaus am Hauptbahnhof**
**W-5000 Köln 1(DE)**

(54) Improved elastomeric layer for multilayer tonable photosensitive elements.

(57) Photosensitive elements are disclosed having a photosensitive layer and an elastomeric layer that is the polymer of an alpha-olefin having at least 5 backbone carbon atoms. The elements are useful to produce colored images, such as for colorproofing.

EP 0 451 735 A2

## Field of the Invention

This invention relates to a multilayer, tonable photosensitive element for image reproduction. More particularly it relates to an improved element having a photosensitive layer and an elastomeric layer that is a homopolymer or copolymer of an alpha-olefin.

## Background of the Invention

Photosensitive elements for image-reproduction are well-known in the graphics arts industry. Such elements usually are exposed to actinic radiation through an image-bearing transparency, such as a color separation transparency, to produce an image that is either a positive or negative of the transparency. Positive-working elements produce a duplicate image of the transparency; that is, the colored and uncolored regions of the transparency are respectively colored and uncolored in the imaged element. Negative-working elements produce an image that is the reverse of the transparency through which they are exposed. After imagewise exposure, the photosensitive element is developed by washout of soluble image areas, by peeling the element apart, by toning with a colorant, or by a combination of these techniques.

Multilayer tonable photosensitive elements having a photosensitive layer, an elastomeric layer, and a support are well known. The photosensitive layer undergoes a photoinitiated reaction which changes its physical properties such that either the exposed or the unexposed areas can be removed during processing to reveal the elastomeric layer. Then, the revealed elastomeric layer is toned to produce a colored image. The colored image can be used as a single color proof, or several colored images can be assembled to form a multi-color proof. U.S. Patent 4,174,216 to Cohen and Fan discloses photosensitive elements of this type wherein the tacky elastomeric layer is, for example, a butadiene or isoprene polymer, or a random, teleblock or block copolymer of butadiene and isoprene copolymerized with styrene.

Since the production and mounting of printing plates is expensive and time consuming, it is essential that the proof accurately predict the appearance and quality of the image that will be obtained by printing. The proof not only must match the resolution and hue of the printed product, but also must faithfully represent the intensity, or density, of each color.

Conventional tonable elements containing a tonable elastomeric layer do not accurately reproduce images with high color densities to the extent desired. It is difficult to reproduce these images since the intensity of color is limited by the amount of toner that the elastomeric layer will accept. Thus, a need exits for a tonable photosensitive element that will provide images having excellent resolution and high color densities.

## Summary of the Invention

This invention provides an improved tonable photosensitive element that provides images with good resolution and high color density. The element has a photosensitive layer and an elastomeric layer that is the polymer of an alpha-olefin having at least 5 carbon atoms in its backbone. The alpha olefin is a linear alpha olefin, one branched at the C4 or higher position, or a mixture of such olefins. Other monomer units may be present to modify elastomeric properties of the polymer. In a preferred embodiment the polymer has a weight average molecular weight ($\overline{M}w$)of at least approximately 2 million.

The element may be either a peel-apart element or a solvent-processable element. When the element is a peel-apart element, the photosensitive layer is photopolymerizable and the element additionally has a transparent coversheet. When the element is solvent-processable, the photosensitive layer is either photosolubilizable or photoinsolubilizable.

## Detailed Description of the Invention Multilayer, Tonable Photosensitive Elements

Multilayer, tonable photosensitive elements have a photosensitive layer, an elastomeric layer, and a support. On exposure, the physical properties of the photosensitive layer are altered such that either the exposed or the unexposed areas can be removed during processing to reveal the tonable elastomeric layer. If the exposed areas are removed, the element is negative working with respect to the transparency through which the element was exposed. If the unexposed areas are removed, the element is positive working with respect to the transparency.

The revealed elastomeric layer accepts toner during the toning step. Excess toner is removed from the element, leaving the imaged photosensitive layer, toned elastomeric layer, and support. Optionally, and depending on the nature of the element, the remaining photosensitive layer may be removed from the element by further processing after the toning step. The support provides dimensional stability for the toned elastomeric layer.

Elastomeric Layer

The elastomeric layer is a tacky deformable organic material. It must be substantially nonmigratory into the photosensitive layer. Components from the photosensitive layer should not diffuse into the elastomeric layer. It must also accept high levels of toner so that the colored image can reproduce the full range of color densities produced by printing.

It now has been found that polymers of alpha-olefins having at least 5 carbon atoms may be selected to particular advantage as the elastomeric layer. The olefin may be linear, such as in poly(1-pentene), or branched provided that the branching is in a C4 or higher position. The alpha-olefin will typically have up to 10 carbon atoms in its backbone. Higher alpha-olefins may be selected in preparing the polymer, but they tend to be more expensive. Representative useful monomers include 1-pentene, 1-hexane, 1-heptene, 1-octene, 1-nonene, 1-decene, and branched monomers such as 4-methyl-1-pentene and 5-methyl-1-hexene. The elastomer may be a homopolymer, a copolymer of two or more alpha-olefin monomers, or a copolymer of at least one alpha-olefin monomer and another monomer that will copolymerize therewith. For example, minor amounts of ethylene and/or propylene may be copolymerized to modify elastomeric properties of the alpha-olefin polymer. The elastomeric copolymer generally will contain at least 50%, by weight, of a C5 or higher alpha-olefin. These alpha-olefin homopolymers and copolymers are prepared using conventional Ziegler-Natta olefin polymerization techniques or other catalyst systems such as aluminum supported tetra-(neophyl)-zirconium.

It generally is desired to produce images with high toned color density, which is a measure of the light intensity reflected by the toned image. To determine toned color density, the yellow, magenta, cyan, or black toned image is illuminated with light of an appropriate wavelength (the cyan image is illuminated with red light, etc.) and the intensity of the reflected light is measured. The intensity of the reflected light is compared with the amount of light reflected by the unimaged receptor, using the formula:

Toned Color Density $= \log(I_{Rec}/I_{Image})$
where:
$I_{Rec}$ = the amount of light reflected by the receptor
$I_{Image}$ = the amount of light reflected by the image

Thus, an image with a toned color density of 1 reflects 10% of the incident radiation; one with a toned color density of 2 reflects one percent of the incident radiation; etc.

Elements having the improved elastomeric layer of this invention achieve higher toned color densities than those obtained with prior art elastomeric layers, and thus more nearly reproduce the range of color intensities produced by printing. Moreover, image resolution is improved since the alpha-olefin polymers may be applied at lower coating weights (i.e., thinner layers may be used than with prior art elastomeric layers). The selected alpha-olefin polymer must have sufficiently high molecular weight, however, that it does not creep to cause image distortion. Accordingly, the polymer generally will have a weight average molecular weight of at least about 2 million.

The elastomeric layer is present on a support that provides stiffness and dimensional stability for the element. For solvent-processable photosensitive elements, the support must be resistant to the processing solvent. Polyethylene terephthalate film is a preferred support.

The alpha-olefin elastomeric layer may be substituted for the elastomeric layer previously used in a variety of prior art photosensitive elements, such as peel-apart and solvent-processable elements.

Peel-Apart, Tonable Photosensitive Elements

Peel-apart, tonable photosensitive elements having a coversheet, a photosensitive layer, an elastomeric layer, and a support are well-known in the art. Such elements are disclosed in Cohen and Fan, U.S. Patents 4,247,619 and 4,282,308. The photosensitive layer is a photopolymerizable composition; i.e., a photopolymerizable, photocrosslinkable, and/or photodimerizable composition. Before exposure, the photopolymerizable layer adheres more strongly to the elastomeric layer than to the coversheet. After imagewise exposure, the exposed areas of the photopolymerizable layer adhere more strongly to the coversheet than to the elastomeric layer and are removed with the coversheet.

The photopolymerizable composition generally contains an organic polymeric binder, an ethylenically unsaturated monomer, and a photoinitiator system. For example, a representative composition contains poly(methyl methacrylate) binder, a monomer that is the diacrylate or dimethacrylate ester of the epichlorohydrin adduct of bis-phenol A, and a 2-o-chlorosubstituted hexaphenylbisimidazole photoinitiator. A sensitizer, such as 7-diethylamino-4-methylcoumarin, and a hydrogen donor, such as 2-mercaptobenzoxazole, also generally are present.

The coversheet is transparent to actinic radiation since irradiation is carried out through the coversheet. The topography of the coversheet may be altered, and its polarity increased, by electrostatic discharge treatment (Buzzell, U.S. Patent 4,356,253) or flame treatment with an air-propane flame. A preferred material is electric discharge treated polyethylene terephthalate film.

Positive working, peel-apart photosensitive elements are disclosed in Cohen and Fan, U.S. Patent 4,304,839, wherein chlorinated rubber, a rubber/poly(methyl methacrylate) mixture, and an acrylonitrile/styrene/butadiene/methyl methacrylate copolymer are disclosed as the binder.

## Solvent-Processable, Tonable, Photosensitive Elements

Solvent-processable, tonable photosensitive element have a photosensitive layer, an elastomeric layer, and a support. The photosensitive layer is either photosolubilizable (i.e., it becomes soluble in the processing solvent when exposed to actinic radiation) or photoinsolubilizable (i.e., it becomes insoluble in the processing solvent when exposed to actinic radiation).

Fan, U.S. Patent 4,053,313, discloses positive working, solvent processable elements wherein the photosensitive layer is a photopolymerizable layer similar to that used in conventional negative working peel-apart photosensitive elements. Processing is by washing out with an organic solvent.

Speckler, U.S. Patent 4,376,158, discloses negative working, solvent processable elements wherein the photosolubilizable layer is a naphthaquinone diazide sensitized Novalac resin. Washout is with aqueous sodium hydroxide.

Fan, U.S. Patent 4,053,313, discloses negative working, solvent processable elements. The photosensitive layer is a photopolymerizable layer similar to that used in conventional negative working peel-apart photosensitive elements except that a nitroaromatic photoinhibitor is used to reverse the normal behavior of the photopolymerizable layer.

## Exposure/Image Formation

Any convenient source may be selected to provide actinic radiation absorbed by the photosolubilizing agent. "Actinic radiation" is any radiation which initiates imaging. The radiation can be natural or artificial, monochromatic or polychromatic, incoherent or coherent. For efficient image formation most of the actinic radiation should be absorbed by the photoactive agent. Conventional source of actinic radiation include fluorescent, mercury vapor, mercury-xenon, metal additive, and arc lamps. Useful sources of coherent radiation are lasers whose emissions fall within or overlap the absorption bands of the photoactive agent. Exposure is conventionally carried out through an image-bearing transparency, preferably a half-tone or continuous tone color separation transparency. However, other means, such as a modulated scanning laser beam, CRT (cathode ray tube), and the like, are alternative ways of imagewise exposing the elements.

Following exposure and processing, the element is colored by applying a suitable colorant, generally known as a toner. After the excess toner is removed, toner will remain only on the imaged area in the case of negative working elements, or on the unimaged area in the case of positive working elements. Representative toners are described in Chu et al., U.S. Patent 3,620,726; Gray, U.S. Patent 3,909,282; Manger et al., U.S. Patent 4,215,193; and Ruskin, U.S. Patent 4,661,439. Toners may be applied by dusting with pads dipped in toners (Burg et al., U.S. Patent 3,060,024); transfer (Burg et al., U.S. Patent 3,060,025); hand-operated machine toning (Sandner, U.S. Patent 4,019,821); and automatic toning (Tobias, U.S. Patent 4,069,791).

The elements of this invention are useful for preparing colored images in general. These images are particularly useful in the graphic arts field, especially for color proofing in which proofs are prepared to duplicate the images produced by printing.

The invention will now be further described by the following examples which illustrate, but do not limit, the invention.

## EXAMPLES

## GLOSSARY

4

| ATASS | Anthracene aryl sulfonium salt; sulfonium, [4-[3-(9-anthracenyl)propyl]-phenyl]diphenyl-, hexfluoroantimonate[-1] |
|---|---|
| o-Cl-HABI | 1,1'-Biimidazole, 2,2'-bis [o-chlorophenyl]-4,4',5,5'-tetraphenyl-; CAS 1707-68-2 |
| Ebecryl® 3704 | Acrylated esters of epoxy resins; Rad-Cure, Louisville, KY |
| Elvacite® 2051 | Poly(methyl methacrylate); MW 350,000 |
| Gentro® 1506 | Styrene-butadiene random copolymeric rubber; Gen Corp.; Akron, OH |
| Irganox® 1010 | Tetra-bis methylene 3-(3,5-di-tert-butyl-4-hydroxyphenyl) propionate methane; Ciba-Geigy, Hawthorne, NY |
| 2-MBO | 2-Mercaptobenzoxazole; 2-Benzoxazolethiol; CAS 2382-96-9 |
| Melinex® 944 | Filled polyester sheet with a subbed coating; ICI Americas, Wilmington, DE |
| Nordel® 2522 | Nordel® 2522 hydrocarbon rubber; ethylene/propylene terpolymer with a small amount of non-conjugated diene; MW about 200,000; E. I. du Pont de Nemours and Company, Wilmington, DE |
| Polyox® WSRN 3000 | Polyethylene oxide, MW 400,000; Union Carbide, Danbury, CT |
| Taktene® 221 | Poly (cis-butadiene); B. F. Goodrich |
| Tetra(neophyl)-zirconium | Tetrakis-(2-methyl-2-phenylpropyl)-ziconium; CAS 56797-10-5 |
| THPA | Tetrahydropyranyl acrylate |
| Tinopal® PCR | Stilbene-naphthotriazole; Ciba-Geigy, Hawthorne, NY |
| Tinopal® SFG | 3-Phenyl-7-[2'-(4'-N,N-diethylamino-6'-chloro-1',3',5'-triazinylamino]-coumarin; Ciba-Geigy, Hawthorne, NY |
| Tinuvin® 328 | 2-(2'-Hydroxy-3',5'-di-tert-amylphenyl)-benzotriazole; Ciba-Geigy, Hawthorne, NY |
| TTEB | 1-Trimethylsiloxy-1-(2-trimethylsiloxyethoxy)-2-methyl-1-propene |

Control Examples A-B and Examples 1-4

These examples compare the image quality obtained with elements using the elastomeric layers of this invention with the image quality obtained with elements using other elastomeric materials. Control example A is a commercial multi-layer, peel-apart, tonable photosensitive element (Du Pont Cromalin® C/N negative off-press proofing film). Control example B uses Nordel® 2522, a conventional hydrocarbon rubber. Examples 1-7 use elastomeric layers of this invention. The coating weight of the elastomeric layer, the toned color density obtained for each of the four color images, and the image resolution are given in Table 1.

Table 1

| Example | Coating Weight[a] | Toned Color Density | | | | Resolution[b] |
|---|---|---|---|---|---|---|
| | | Yellow | Magenta | Cyan | Black | |
| Control A | 125 | 1.14 | 1.41 | 1.20 | 1.56 | 2-96% |
| Control B | 117 | ND[c] | 1.30 | ND | ND | 3-96% |
| 1 | 45-51 | 1.71 | 2.00 | 1.51 | 1.97 | 2-98% |
| 2 | 40.5 | 1.68 | 2.23 | 1.63 | 1.99 | 1-98% |
| 3 | 46.7 | 1.64 | 2.05 | 1.61 | 1.95 | 1-98% |
| 4 | 57.3 | ND | 1.83 | ND | ND | 1-95% |
| 5 | 66.2 | 1.69 | 2.25 | 1.92 | 2.01 | 1-98% |
| 6 | 39.0 | 1.69 | 2.17 | 1.76 | 2.00 | 1-98% |
| 7 | 40.7 | 1.65 | 2.35 | 1.74 | 1.99 | 2-98% |

a   Coating weight of the elastomeric layer in $mg/dm^2$.

b   Dots held with a 150 lines/in (60 lines/cm) screen on a magenta image.

c   ND – Not determined.

Control Example A

Photopolymerizable Layer The photopolymerizable composition, described in Table 2, was coated onto an about 0.48 mil (12.2 micron) thick clear polyethylene terephthalate coversheet, which had been surface treated by electrostatic discharge at about 0.05 coulomb/ft$^2$ (0.544 coulomb/m$^2$), using conventional coating techniques. Coating conditions were: 22.5% solids from 96:4 dichloromethane/methanol; coating weight about 36 mg/dm$^2$; coating thickness about 0.15 mil (3.8 micron). Following coating, a polyethylene release film was placed on top of the photopolymerizable layer to protect it until the rest of the element was formed.

## TABLE 2

### Composition of the Photopolymerizable Layer[a]

| | |
|---|---|
| Elvacite® 2051 | 43.51 |
| Ebecryl® 3704 | 49.79 |
| o-Cl HABI | 2.50 |
| 2-MBO | 1.50 |
| Tinopal® PCR | 0.50 |
| Tinopal® SFG | 1.50 |
| Tinuvin® 328 | 0.20 |
| Polyox® WSRN 3000 | 0.50 |

[a]in percent by weight

Elastomeric Layer An elastomeric layer of 79.5% Taktene® 221, 20.0% Gentro® 1506, and 0.5% of Irganox® 1010 was coated onto 2 mil (50 micron) thick silicon release treated polyethylene terephthalate support. Coating conditions: 7.7% sclids in dichloromethane; coating weight about 125 mg/dm².

Photosensitive Element The release film was removed from the photopolymerizable layer formed above, and the photopolymerizable layer laminated to the elastomeric to form a photosensitive element consisting of: silicon release treated polyethylene terephthalate support, elastomeric layer, photopolymerizable layer, and coversheet.

Proof Formation The support was removed from the photosensitive element and the revealed elastomeric layer laminated to a Du Pont Cromalin® CR/1 Receptor to form an element consisting of receptor, elastomeric layer, photopolymerizable layer, and coversheet. This element was placed in a vacuum frame with the coversheet up. A yellow Cromalin® offset COM guide/System Brunner test form was placed on top of the coversheet with the emulsion side in contact with the coversheet. A vacuum was drawn on the element and transparency for 90 sec prior to exposure. The element was exposed for about 36 sec with the radiation from an unfiltered 5 kw high pressure mercury vapor lamp (Violux® 5002S, Exposure Systems Company, Bridgeport, CT, equipped with a photopolymer bulb) about 54 in (137 cm) above the element and transparency.

The exposed element was removed from the vacuum frame and placed on a vacuum easel. The coversheet was removed by peeling back at 180° ("peel-back mode") in a smooth, continuous motion. The revealed portions of the elastomeric layer were toned with Du Pont negative Cromalin® yellow toner using a Du Pont Automatic Toning Machine to produce a yellow, one-color image consisting of receptor, yellow toned elastomeric layer, and exposed and peeled-apart photopolymerizable layer.

The support was removed from a second photosensitive element and the revealed elastomeric layer laminated to the one color image to form an element consisting of receptor, yellow toned elastomeric layer, exposed and peeled-apart photopolymerizable layer, elastomeric layer, photopolymerizable layer and coversheet. This element was exposed in register as previously described using the magenta test form, peeled-part, and toned with a magenta toner. The final element was a two-color image consisting of: receptor, yellow toned elastomeric layer, exposed and peeled-apart photopolymerizable layer, magenta toned elastomeric layer, and exposed and peeled-apart photopolymerizable layer.

This process was repeated with first the cyan and then the black test form, and their corresponding toners, to produce a four-color image consisting of: receptor, yellow toned elastomeric layer, exposed and peeled-apart photopolymerizable layer, magenta toned elastomeric layer, exposed and peeled-apart photopolymerizable layer, cyan toned elastomeric layer, exposed and peeled-apart photopolymerizable layer, black toned elastomeric layer, and exposed and peeled-apart photopolymerizable layer. The image was protected by a layer of conventional Cromalin® off-press press proofing system topcoat.

Toned Color Densities Toned color densities were measured by determining the reflectance of a solid colored image. Each of the test forms contains a solid image which can be used to make this measurement. The measurement was made with a MacBeth RD 918 reflection densitomer which measures the amount of light reflected by the solid image. The instrument contains a series of filters so that each image may be illuminated with light appropriate for the colored image being evaluated. (The cyan image is illuminated with red light, etc.) The intensity of the reflected light is compared to the amount of light reflected by the receptor, so that:

$$\text{Toned Color Density} = \log(I_{Rec}/I_{Image})$$

where:

$I_{Rec}$ = the amount of light reflected by the receptor

$I_{Image}$ = the amount of light reflected by the image

This instrument also measures dot gain at 50% dots.

Resolution Following the procedure described above, a magenta image was formed using a UGRA target. Resolution was determined by reading the highlight and shadow dots from the 150 lines/in (60 lines/cm) screen of this image. Dot gain at 50% dots (magenta image) was 23-27%.

Example 1

Photopolymerizable Layer The photopolymerizable composition, described in Table 2, was coated onto an about 0.48 mil (12.2 micron) thick electric discharge treated clear polyethylene terephthalate coversheet using conventional coating techniques. Coating conditions were: 21.9% solids from dichloromethane; coating weight about 15.3 mg/dm². Following coating, a polyethylene release film was placed on top of the photopolymerizable layer to protect it until the rest of the element was formed.

Elastomeric Layer The elastomeric layer was poly(l-octene) ($M_n$ about 300,000; $M_w$, about 2.0 million) prepared by the titanium trichloride:triethyl aluminum catalyzed polymerization of 1-octene. This was coated onto a 0.92 mil (23 micron) thick silicon release treated polyethylene terephthalate support. Coating conditions: 5.0% solids in toluene; coating weight about 45-50 mg/dm².

The photosensitive element was formed by lamination of the photopolymerizable layer to the elastomeric layer as described in Control Example A. A four color image was formed and evaluated as described in Control Example A. Dot gain at 50% dots was 20-22%.

Example 2

The photosensitive element was formed as described in Example 1 except that: (1) the photopolymerizable layer had a coating weight of 22.5 mg/dm², (2) the elastomeric layer was poly(1-octene) ($M_n$ greater than or equal 1.3 million and a $M_w$ greater than or equal to 2.7 million) prepared by the alumina supported tetra(neophyl)-zirconium polymerization of 1-octene (Example 8), and (3) the elastomeric layer was coated at 40.5 mg/dm². The element was formed and evaluated as described in Control Example A. Dot gain at 50% dots was 17-18%.

Example 3

The photosensitive element was formed as described in Example 1 except that: (1) the photopolymerizable layer had a coating weight of 22.8 mg/dm², (2) the elastomeric layer was poly(1-octene) ($M_n$ greater than or equal 1.8 million and a $M_w$, greater than or equal to 4.6 million) prepared by the alumina supported tetra(neophyl)-zirconium polymerization of 1-octene, and (3) the elastomeric layer was coated at 46.7 mg/dm². The element was formed and evaluated as described in Control Example A. Dot gain at 50% dots was 17-18%

Example 4

The photosensitive element was formed as described in Example 1 except that: (1) the elastomeric layer was 50:50 (by volume) poly(1-octene/4-methyl-1-pentene) ($M_n$ greater than or equal 1.2 million and a $M_w$ greater than or equal to 2.6 million) prepared by alumina supported tetra(neophyl)-zirconium polymerization of a 1:1 mixture of olefins, and (2) the elastomeric layer was coated at 57.3 mg/dm². The element was formed and evaluated as described in Control Example A except that only a magenta image was prepared. Dot gain at 50% dots was 21%

Example 5

The photosensitive element was formed and evaluated as described in Example 1 except that: (1) the elastomeric layer was poly(1-pentene) ($M_w$, greater than 400,000) prepared by titanium trichloride:triethyl aluminum catalyzed polymerization of 1-pentene, and (2) the elastomeric layer was coated at 66.2 mg/dm$^2$. Dot gain at 50% dots was 18%.

Example 6

The photosensitive element was formed and evaluated as described in Example 1 except that: (1) the elastomeric layer was a 9:1 1-pentene/1-octene copolymer ($M_w$ about 1.5 million; Mn about 80,000) prepared by titanium trichloride:triethyl aluminum catalyzed polymerization of the olefin mixture, and (2) the elastomeric layer was coated at 39.0 mg/dm$^2$. Dot gain at 50% dots was 17%.

Example 7

The photosensitive element was formed and evaluated as described in Example 1 except that: (1) the elastomeric layer was a poly(1-decene) ($M_w$ abut 3.9 million; $M_n$ about 1.2 million) prepared by the alumina supported tetra (neophyl)-zirconium catalyzed polymerization of 1-decene, and (2) the elastomeric layer was coated at 40.7 mg/dm$^2$. Dot gain at 50% dots was 18%.

Control Example B

The photosensitive element was formed as described in Example 1 except that the elastomeric layer was Nordel® 2522 rubber. The element was formed and evaluated as described in Control Example A except that only a magenta image was prepared. Dot gain at 50% dots was 17 to 22%.

Example 8

This example describes the synthesis of the poly(1-octene) used in Example 2.

In a nitrogen drybox, tetra(neophyl)-zirconium (0.25 g) (Setterquist, U.S. Patent 4,017,525) was dissolved in 16 g of hexane. Alumina (2.0 g) was slurried in 20 g of hexane and the tetra(neophyl)-zirconium solution added. The resulting mixture was mixed with a biohomogenizer and placed in a bottle capped with a septum.

1-Octene was stirred over sodium for 24 h, filtered, and 500 mL transferred under argon to a 1 L Buchi stirred glass autoclave via cannula. The 1-octene was cooled to 0°C and the catalyst cannulated into the reactor. The reaction mixture was stirred for a few minutes until the polymer began to form.

The autoclave was heated from 0°C to 10°C over a period of 0.5 h; from 10°C to 30°C over 0.5 h; from 30°C to 40°C over 0.5 h; from 40°C to 45°C 0.5 h; and from 45°C to 50°C over 1 h; from 50°C to 55°C over 2 h; and from 55°C to 70°C over 25 h. The autoclave was held at 70°C for 8 h. The polymer was removed from the autoclave and air-dried to remove residual monomer.

Molecular weight was determined by size exclusion chromatography and are minimum values since the high molecular weight component was not separated by the column. $M_n$ greater than or equal 1.3 million. $M_w$ greater than or equal to 2.7 million.

Example 9

This example illustrates the preparation of the homopolymer of THPA used in Example 10 by group transfer polymerization. The preparation of THPA is described in J. E. Kearns, C. D. McLean, and D. H. Solomon, J. Macromol. Sci.-Chem., A8 (4), 673-685, 1974.

During a period of 20 min, 0.8 mL of 0.01 M tetrabutyl ammonium acetate in tetrahydrofuran was added dropwise to a solution of 15.6 g (14.6 mL, 100 mmol) of THPA and 0.3 mL (1 mmol) of TTEB in 70 mL of anhydrous tetrahydrofuran cooled to 0°C. Exothermic polymerization occurred. The reaction mixture was allowed to warm to room temperature and was quenched with 0.1 mL of methanol. The poly(2-tetrahydropyranyl acrylate) was precipitated in hexane at -70°C and dried in vacuum at room temperature to yield 11.3 g of polymer. Gel permeation chromatography: $M_n$ 14,400; $M_w$ 32,700; $M_w/M_n$ 2.26.

Example 10

9

This example illustrates the preparation of a solvent processable photosensitive element and the formation of a colored image therefrom.

Step 1. Elastomeric Layer A solution of poly(1-octene) ($M_n$ about 300,000; $M_w$ about 2.0 million, prepared by the titanium trichloride:triethyl aluminum catalyzed polymerization of 1-octene) dissolved in toluene (1.5% solution) was coated onto a Melinex® 944 support using a doctor knife with a 3 mil (75 micron) gap. The coating was allowed to air dry to produce an element consisting of: support and poly(1-octene) elastomeric layer.

Step 2. Photosensitive Element A solution of the homopolymer of THPA prepared in Example 9 (10% in the coating solution) and ATASS (0.25% in the coating solution; about 2.5% in the dry coating) (M. D. Tilley, Ph.D. Thesis, North Dakota State University, Fargo, ND, 1988) in 2-butanone was coated onto the elastomeric layer using a doctor knife with a 1 mil (25 micron) gap. The coating was allowed to air dry to produce a photosensitive element consisting of: support; elastomeric layer; and photosolubilizable layer.

Step 3. Exposure A USRA target (Graphic Arts Technical Foundation, Pittsburgh, PA) was placed on top of the element formed in Step 2 with the emulsion side in contact with the photosolubilizable layer. The element and target were placed in a vacuum frame and a vacuum drawn. The element was exposed for 5 sec to the output a Violux 5002 S lamp mounted in a Douthitt DCOP-X (Douthitt Corp., Detroit, MI) exposure unit.

Step 4. Image Formation The exposed element was allowed to stand at room temperature for about 2-3 min. Then it was washed out with room temperature tap water. During washout the photosolubilizable layer was gently rubbed with cotton. Then it was dried with and air gun and toned with a Du Pont negative Cromalin® toner. Image quality as a function of washout time is given in the following table.

| Washout Time (sec) | Image Quality (Dots Held) |
|---|---|
| 10 | 0.5-99.5% |
| 20 | 0.5-98% |
| 40 | 0.5-99.5% |
| 60 | 0.5-99% |
| 300 | 0.5-99% |

Longer exposure times (up to 20 sec) produced images which were inferior to those described above.

Having described the invention, we now claim the following and their equivalents.

**Claims**

1. In a photosensitive element having a photosensitive layer and a tonable elastomeric layer, the improvement wherein the elastomeric layer is the polymer of at least one linear alpha-olefin, branched alpha-olefin wherein the branching is in the C4 or higher position, or mixture thereof, said alpha-olefin having at least 5 carbon atoms in its backbone.

2. The element of claim 1 wherein said polymer has a weight average molecular weight of at least approximately 2 million.

3. The element of claim 1 wherein said polymer contains up to 50%, by weight, units of an additional monomer.

4. The element of claim 3 wherein said additional monomer is ethylene, propylene, or a mixture thereof.

5. The element of claim 1 or 3 wherein the alpha-olefin has 5 to 10 carbon atoms in its backbone.

6. The element of claim 1 or 3 wherein said polymer contains units of 1-pentene, 1-hexene, 1-heptene, 1-octene, 1-nonene, 1-decene, or mixtures thereof.

7. The element of claim 1 or 3 that is solvent-processable.

8. The element of claim 1 or 3 that is peel-apart.

9. The element of claim 1 wherein the elastomeric layer is poly(1-octene).